# EUROPEAN PATENT SPECIFICATION

(11) **EP 3 706 523 B1**
(45) Date of publication and mention of the grant of the patent: **13.08.2025**
(21) Application number: 18873684.7
(22) Date of filing: 25.10.2018
(51) Int. Cl.: H05K 7/20

(54) **COOLING CABINET AND COOLING SYSTEM**
KÜHLSCHRANK UND KÜHLSYSTEM
ARMOIRE DE REFROIDISSEMENT ET SYSTÈME DE REFROIDISSEMENT

(30) Priority: 03.11.2017 CN 201711073039
(43) Date of publication of application: 09.09.2020
(73) Proprietor: Alibaba Group Holding Limited, Grand Cayman (KY)
(72) Inventor: ZHONG, Yangfan, Hangzhou Zhejiang 311121 (CN)
(74) Representative: Barker Brettell LLP
(86) International application number: PCT/CN2018/111821
(87) International publication number: WO 2019/085813

(56) References cited:
- CN-A- 104 284 536
- CN-A- 104 284 536
- CN-A- 105 487 624
- CN-A- 106 255 387
- CN-U- 204 231 772
- CN-U- 204 810 797
- CN-U- 207 519 034
- CN-U- 207 519 035
- US-A1- 2003 123 225
- US-A1- 2015 181 762
- US-A1- 2017 156 233
- US-A1- 2017 265 328

## Description

The present application claims the priority of Chinese Patent Application No. 201711073039.6, entitled "COOLING CABINET AND COOLING SYSTEM" and filed on November 3, 2017.

### Technical Field

The present specification relates to the technical field of cooling devices, and in particular, to a cooling cabinet and a cooling system.

### Background

With the rapid development of cloud computing technology (i.e., large-scale distributed system technology), the requirements for computing performance of servers are getting increasingly higher. While server performance is improving, power consumption is increasing rapidly, and the power consumption of the cabinet has increased exponentially. The data shows that the power density of data center cabinets has increased by nearly 15 times in the past decade. In the past, the power consumption of a cabinet was generally 1.5 kW-2 kW. However, some cabinets have partially reached as high as 20 kW-30 kW.

At present, servers in data centers usually adopt the way of air conditioning and air cooling, which are consuming a large amount of energy, space and cost, and the consumption is increasing. However, with the steady increase in power density, the cooling capacity provided by many data centers is currently approaching the limit, and this trend of rapid increase in power density will have an adverse effect. Therefore, the conventional way of air conditioning and air cooling has been unable to meet the cooling demand of the servers in the data centers.

US2015/181762A1 discloses an appliance immersion tank system comprising a generally rectangular tank adapted to immerse in a dielectric fluid a plurality of appliances, each in a respective appliance slot, and a weir adapted to facilitate substantially uniform recovery of the dielectric fluid flowing through each appliance slot. CN104284536A1 discloses a liquid immersion and cooling server system with a server cabinet. The server cabinet comprises a cabinet body with a bottom wall, an annular side wall, a liquid inlet and a liquid outlet. A containing cavity is formed by the annular side wall and the bottom wall together, and the containing cavity is provided with a server inlet and outlet. A separation plate with a plurality of first flow guide through holes is arranged in the containing cavity to separate it into a liquid collection cavity and a server containing cavity. US 2017/265328 discloses electronic equipment including a refrigerant tank that contains a refrigerant, a plurality of electronic components immersed in the refrigerant, and a refrigerant injection member including a plurality of injection holes to inject the refrigerant so as to cause the refrigerant to flow between the plurality of electronic components. Opening areas of the injection holes of the refrigerant injection member are set to be larger as the injection holes are farther from the refrigerant inlet. US2017/156233 discloses methods of a dry power supply for immersion-cooled Information Handling Systems (IHSs). In some embodiments, an IHS may include: a chassis configured to be at least partially disposed under a surface of a dielectric liquid coolant, where the chassis includes one or more components configured to be cooled by the dielectric liquid coolant during operation of the IHS; and a power supply, in the form of an air fan, coupled to the chassis and configured to provide power to the one or more components.

### Summary of the Invention

The present specification provides a cooling cabinet and a cooling system to improve the cooling efficiency for the servers in a data center.

According to a first aspect of the embodiments of the present specification, provided is a cooling cabinet according to claim 1.

Further, the first diversion inlet may be located above the first diversion outlet; the first diversion assembly may be located at the top of the server devices, and the second diversion assembly may be located at the bottom of the server devices .

Further, the first diversion inlet may be located below the first diversion outlet; the first diversion assembly may be located at the bottom of the server devices, and the second diversion assembly may be located at the top of the server devices.

Further, the loop tube portion may be a rectangular loop tube structure and includes two first tube bodies and two second tube bodies which communicate with each other and are connected into an enclosure; the first diversion portion may be provided in communication with any of the first tube bodies, and at least one of the first tube bodies, the second tube bodies, and the first diversion portion may be provided with the second diversion outlet.

Further, there may be two first diversion inlets, which are respectively disposed on two sides of the cabinet body; there may be two first diversion portions which communicate with the two first tube bodies in one-to-one correspondence.

Further, each of the two first tube bodies may be integrally formed with at least one of the adjacent second tube bodies.

Further, there may be a plurality of second diversion outlets, which are evenly arranged on a side wall of at least one of the first tube bodies, the second tube bodies, and the first diversion portions.

Further, the tube bank portion may be a rectangular tube bank structure and include two third tube bodies and a plurality of fourth tube bodies connected between the two third tube bodies; the plurality of fourth tube bodies may be provided in communication with the two third tube bodies; the second diversion portion may be provided in communication with any of the third tube bodies, and the fourth tube bodies may be provided with the second diversion inlets.

Further, there may be two first diversion outlets, which are respectively disposed on two sides of the cabinet body; there may be two second diversion portions which communicate with the two third tube bodies in one-to-one correspondence.

Further, the plurality of fourth tube bodies may include two groups arranged in a staggered manner; one group of the fourth tube bodies and one of the third tube bodies may be integrally formed, and the other group of the fourth tube bodies and the other third tube body may be integrally formed.

Further, there may be a plurality of the second diversion inlets, which are evenly arranged at the top of the fourth tube bodies.

Further, the loop tube portion may be a rectangular loop tube structure and include two first tube bodies and two second tube bodies which communicate with each other and are connected into an enclosure; the first diversion portion may be provided in communication with any of the first tube bodies, and at least two of the first tube bodies, the second tube bodies, and the first diversion portion may be provided with the plurality of diversion openings.

Further, the tube bank portion may be a rectangular tube bank structure and may include two third tube bodies and a plurality of fourth tube bodies connected between the two third tube bodies; the plurality of fourth tube bodies may be provided in communication with the two third tube bodies; the second diversion portion may be provided in communication with any of the third tube bodies, and the fourth tube bodies may be provided with the plurality of diversion openings.

As can be seen from the above technical solutions, in the cooling cabinet of the present specification, by arranging the first diversion assembly and the second diversion assembly on two opposite sides of the to-be-cooled device, the flow field of the cooling medium flowing through the to-be-cooled device is a straight path, so that the entire liquid flow path of the cooling medium is the shortest, the resistance is the smallest, and the energy consumption required to drive the liquid is correspondingly greatly reduced, thereby achieving the effect of minimum energy consumption. Since a plurality of diversion openings are disposed in a discrete distribution on the diversion assembly, the diversion assembly may be provided in communication with the diversion inlets of the cabinet body, thus introducing the cooling medium. The plurality of diversion openings that are discretely distributed can make the cooling medium flow into or out of the cabinet body from multiple different directions, reducing the temperature difference between the cooling mediums, thereby making the flow and temperature of the cooling medium more uniform and achieving higher cooling efficient. The cooling system drives the cooling medium to circulate in the cooling cabinet through the heat exchanging device to take away the heat of the to-be-cooled device, and exchanges heat with the external liquid supply device through the heat exchanging device, so that the cooling medium reaches a low temperature state again, and circulates into the cooling cabinet to cool the to-be-cooled device again, thus achieving the purpose of circularly and continuously cooling the to-be-cooled device.

### Brief Description of the Drawings

FIG. 1 is a schematic perspective view of a cooling cabinet according to an exemplary embodiment of the present disclosure;
FIG. 2 is a schematic perspective view of a cooling cabinet according to an exemplary embodiment of the present disclosure, with a cover removed;
FIG. 3 is a schematic perspective view of a cooling cabinet according to an exemplary embodiment of the present disclosure, with a cover and a cabinet body removed;
FIG. 4 is a schematic perspective view of a first diversion assembly and a second diversion assembly in a cooling cabinet according to an exemplary embodiment of the present disclosure;
FIG. 5 is a schematic view of a flow field of a cooling cabinet according to an exemplary embodiment of the present disclosure;
FIG. 6 is a schematic view of a flow field of another cooling cabinet according to an exemplary embodiment of the present disclosure; and
FIG. 7 is a schematic structural diagram of a cooling system according to an exemplary embodiment of the present specification.

### Detailed Description

Exemplary embodiments will be described in detail herein, examples of which are illustrated in figures. When the following description refers to figures, same numerals in different figures refer to the same or similar elements, unless otherwise indicated. The implementations described in the following exemplary embodiments do not represent all implementations consistent with the present specification. Instead, they are merely examples of devices and methods consistent with some aspects, as detailed in the appended claims, of the present specification.

The terminology used in the present specification is for the purpose of describing specific embodiments, but not intended to limit the present specification. The singular forms "a", "said" and "the" as used in the present specification and the appended claims are also intended to include plural forms unless otherwise other meanings are explicitly indicated in the context. It also should be understood that the term "and/or" as used herein refers to encompassing any or all possible combinations of one or more associated listed items.

It should be understood that although the terms "first", "second", "third", etc. may be used in the present specification to describe various types of information, such information should not be limited to these terms. These terms are only used to distinguish the same type of information from each other. For example, first information may also be referred to as second information without departing from the scope of the present specification. Similarly, the second information may also be referred to as the first information. It depends on the context; for example, the word "if" as used herein may be interpreted as "at the time of" or "when" or "in response to a determination".

The present specification provides a cooling cabinet and a cooling system to improve the cooling efficiency for the servers in a data center. The cooling cabinet and the cooling system of the present specification will be described in detail below with reference to the drawings. In the case of no conflict, the features in the following embodiments and implementations may be combined with each other.

### Embodiment 1

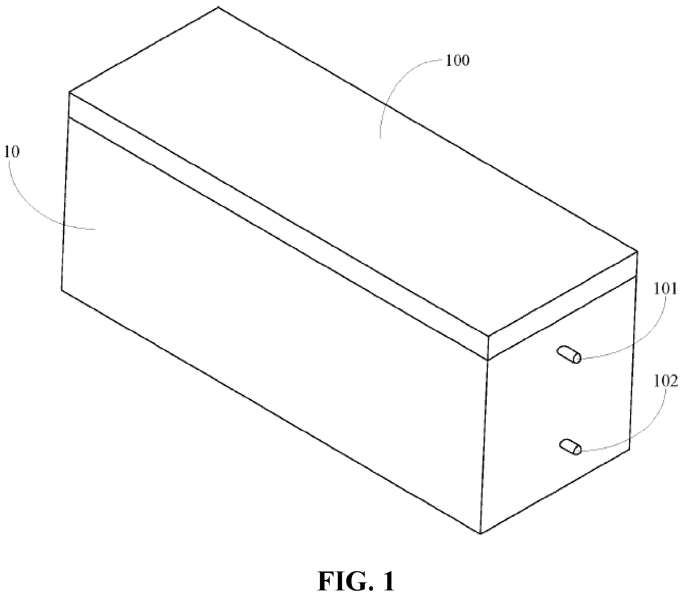

Referring to FIG. 1 to FIG. 4, an embodiment of the present specification provides a cooling cabinet 1 adopting a single-phase immersion liquid cooling technology for cooling a to-be-cooled device 900. The to-be-cooled device 900 may be a server in a data center, or may be other heating devices that need to be cooled. The cooling cabinet 1 includes a cabinet body 10, a first diversion assembly 20 and a second diversion assembly 30. The cabinet body 10 may contain a non-conductive cooling medium for at least partially immersing the to-be-cooled device 900, and the cabinet body 10 is provided with a first diversion inlet 101 for introducing the cooling medium and a first diversion outlet 102 for discharging the cooling medium. The first diversion assembly 20 is provided in communication with the first diversion inlet 101, and the first diversion assembly 20 is provided with a second diversion outlet 200 for discharging the cooling medium into the cabinet body 10; after flowing through the to-be-cooled device 900, the cooling medium can cool the to-be-cooled device 900. The second diversion assembly 30 is provided in communication with the first diversion outlet 102, and the second diversion assembly 30 is provided with a second diversion inlet 300 for introducing the cooling medium flowing through the to-be-cooled device 900. Optionally, the first diversion assembly 20 and the second diversion assembly 30 are both disposed in the cabinet body 10, and the first diversion assembly 20 and the second diversion assembly 30 are respectively located on two sides of the to-be-cooled device. In the example shown in the figures, the first diversion assembly 20 and the second diversion assembly 30 are respectively located on two sides of the to-be-cooled device in the vertical direction, so that the flow field of the cooling medium is a straight path in the vertical direction, which can avoid extra energy consumption due to gravity when the cooling medium moves in the lateral direction. It should be noted that the cooling medium may completely immerse the to-be-cooled device 900, or may partially immerse the to-be-cooled device 900, which may be set according to actual needs. The cooling medium may be a gaseous medium, a liquid medium, or a solid-liquid mixed medium, which may also be set according to actual needs. **In** this embodiment, the cooling medium completely immerses the to-be-cooled device 900, and the cooling medium is a liquid 3M electronic fluorinated liquid. The cooling medium is discharged into the cabinet body 10 through the first diversion assembly 20, and the cooling medium flowing through the to-be-cooled device 900 is discharged out of the cabinet body 10 through the second diversion assembly 30. However, in other embodiments, it is also feasible that the first diversion assembly 20 is provided in communication with the first diversion outlet 102, and the second diversion assembly 30 is provided in communication with the first diversion inlet 101. The setting is equivalent to introducing the cooling medium into the cabinet body 10 through the second diversion assembly 30, and discharging the cooling medium flowing through the to-be-cooled device 900 out of the cabinet body 10 through the first diversion assembly 20.

As can be seen from the above technical solution, in the cooling cabinet 1 of the present specification, the cooling medium enters the cabinet body 10 from the first diversion inlet 101 of the cabinet body 10 and is then discharged to the to-be-cooled device 900 through the second diversion outlet 200 of the first diversion assembly 20; the cooling medium flowing through the to-be-cooled device 900 takes away the heat of the to-be-cooled device 900, and then enters the second diversion assembly 30 through the second diversion inlet 300 of the second diversion assembly 30, and finally is discharged out of the cabinet body 10 through the first diversion outlet 102 of the cabinet body 10. In this way, the purpose of dissipating the heat of the to-be-cooled device 900 is achieved. By arranging the first diversion assembly 20 and the second diversion assembly 30 on two opposite sides of the to-be-cooled device 900, the flow field of the cooling medium flowing through the to-be-cooled device 900 is a straight path, so that the entire liquid flow path of the cooling medium is the shortest, the resistance is the smallest, and the energy consumption required to drive the liquid is correspondingly greatly reduced, thereby achieving the effect of minimum energy consumption. In addition, the cooling medium flows along a linear flow path, and cold and hot fluids are completely isolated, which can prevent the cold and hot fluids from mixing with each other, thereby achieving the optimal cooling effect.

As shown in FIG. 1, in an optional implementation, a cover 100 is detachably disposed at the top of the cabinet body 10 through fasteners. When the to-be-cooled device 900 needs to be placed in the cabinet body 10, the fasteners are removed to open the cover 100, and the to-be-cooled device 900 then can be placed in the cabinet body 10. After the to-be-cooled device 900 is placed in the cabinet body 10, the cover 100 is closed to seal the cabinet body 10.

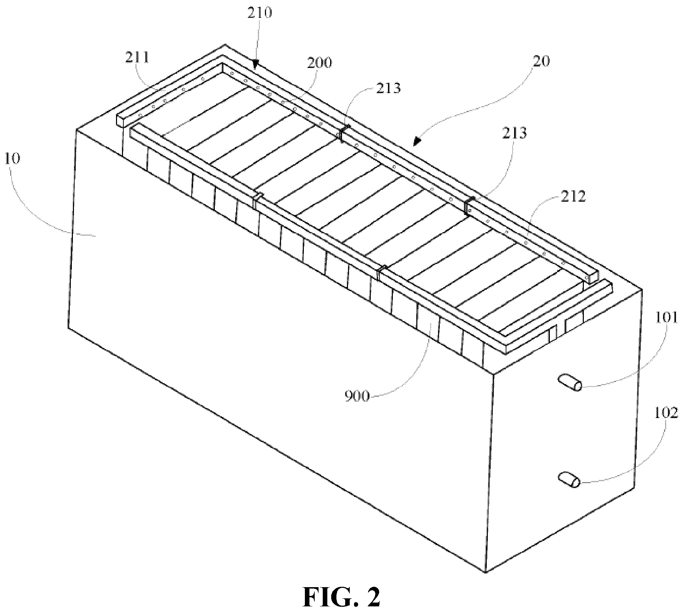

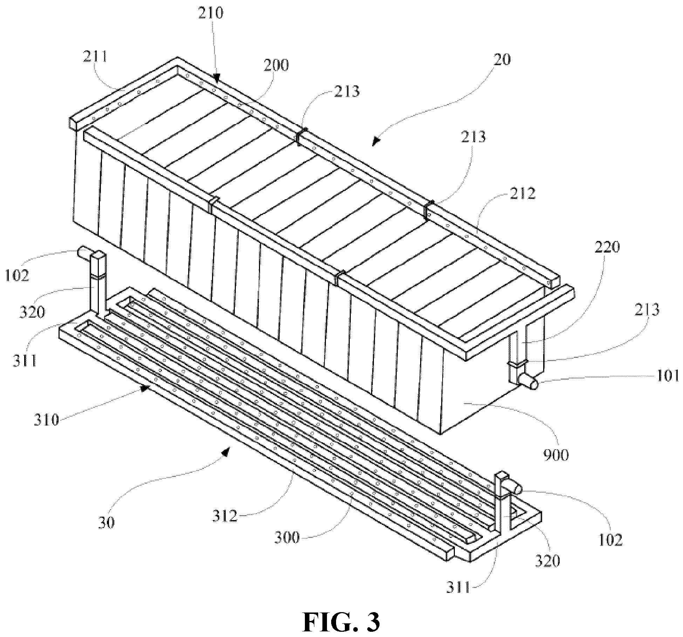

Referring to FIGS. 2 and 3, in an optional implementation, the first diversion inlet 101 are located above the first diversion outlet 102. Accordingly, the first diversion assembly 20 is located at the top of the to-be-cooled device 900, and the second diversion assembly 30 is located at the bottom of the to-be-cooled device 900. However, in another optional implementation, the first diversion inlet 101 may be located below the first diversion outlet 102. Accordingly, the first diversion assembly 20 is located at the bottom of the to-be-cooled device 900, and the second diversion assembly 30 is located at the top of the to-be-cooled device 900. The flow field of the cooling medium flowing through the to-be-cooled device 900 may have a straight path directly from top to bottom or from bottom to top, so that the entire liquid flow path of the cooling medium is the shortest and the resistance is the smallest.

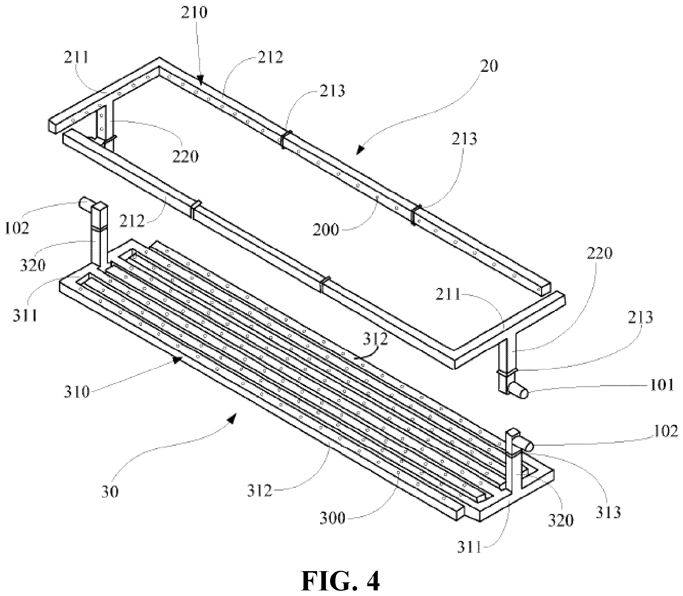

Referring to FIG. 4, in an optional implementation, the first diversion assembly 20 includes a loop tube portion 210 and a first diversion portion 220 provided in communication with the loop tube portion 210, the first diversion portion 220 is provided in communication with the first diversion inlet 101, and at least one of the loop tube portion 210 and the first diversion portion 220 is provided with the second diversion outlet 200. In this embodiment, the loop tube portion 210 and the first diversion portion 220 are both provided with the second diversion outlet 200. After entering the first diversion assembly 20 from the first diversion inlet 101 of the cabinet body 10, the cooling medium is discharged into the cabinet body 10 through the second diversion outlet 200 disposed in the loop tube portion 210 and the first diversion portion 220 and then flows through the to-be-cooled device 900 to cool the to-be-cooled device 900.

Further, the loop structure of the loop tube portion 210 may correspond to the cross-sectional structure of the to-be-cooled device 900, so that the cooling medium flowing out of the first diversion assembly 20 can flow along the periphery of the to-be-cooled device 900 to achieve higher cooling efficiency. For example, the cross-sectional structure of the to-be-cooled device 900 is rectangular, and the loop tube portion 210 is a rectangular loop tube structure corresponding to the cross-sectional structure. However, the cross-sectional structure of the to-be-cooled device 900 may also be other shapes, and it is required that the loop structure of the loop tube portion 210 corresponds to the cross-sectional structure.

In an optional implementation, the cross-sectional structure of the to-be-cooled device 900 is rectangular, and the loop tube portion 210 is a rectangular loop tube structure corresponding to the the cross-sectional structure. The loop tube portion 210 includes two first tube bodies 211 and two second tube bodies 212 which communicate with each other and are connected into an enclosure; the first diversion portion 220 is provided in communication with any of the first tube bodies 211, and at least one of the first tube bodies 211, the second tube bodies 212, and the first diversion portion 220 is provided with the second diversion outlets 200 in the side wall. In this embodiment, the inner walls of the first tube bodies 211, the first tube bodies 212 and the first diversion portion 220 are all provided with the second diversion outlets 200. After entering the first diversion assembly 20 from the first diversion inlet 101 of the cabinet body 10, the cooling medium is discharged into the cabinet body 10 through the second diversion outlet 200 disposed in the first tube bodies 211, the second tube bodies 212 and the first diversion portion 220 and then flows through the to-be-cooled device 900 to cool the to-be-cooled device 900.

In an optional implementation, there are two first diversion inlets 101 disposed on two sides of the cabinet body 10 respectively. Correspondingly, there are two first diversion portions 220 which communicate with the two first tube bodies 211 in one-to-one correspondence. In this way, the circulation speed of the cooling medium can be increased, and further the cooling efficiency of the to-be-cooled device 900 can be improved.

In an optional implementation, the length of the first tube body 211 is shorter than the length of the second tube body 212; a reinforcing ring 213 is fitted on the first tube body 211, and a plurality of reinforcing rings 213 are fitted on the second tube body 212 at intervals, which can enhance the structural strength of the first diversion assembly 20. Further, each of the two first tube bodies 211 is integrally formed with at least one of the adjacent second tube bodies 212. That is, each of the two first tube bodies 211 may be formed integrally with the corresponding one of the two second tube bodies 212, or the two first tube bodies 211 and the two second tube bodies 212 are integrally formed respectively, which can further enhance the structural strength of the first diversion assembly 20. It should be noted that term "a plurality of" used herein refers to two or more.

In an optional implementation, the second diversion assembly 30 includes a tube bank portion 310 and a second diversion portion 320 provided in communication with the tube bank portion 310, the second diversion portion 320 is provided in communication with the first diversion outlet 102, and the tube bank portion 310 is provided with the second diversion inlet 300. The cooling medium flowing through the to-be-cooled device 900 takes away the heat of the to-be-cooled device 900, and then enters the second diversion assembly 30 through the second diversion inlet 300 disposed on the tube bank portion 310, and finally is discharged out of the cabinet body 10 through the first diversion outlet 102 of the cabinet body 10. In this way, the purpose of dissipating the heat of the to-be-cooled device 900 is achieved.

Further, the tube bank structure of the tube bank portion 310 may correspond to the cross-sectional structure of the to-be-cooled device 900, so that the cooling medium flowing through the to-be-cooled device 900 can flow into the second diversion assembly 30 as much as possible and then is discharged from the first diversion outlet 102 of the cabinet body 10, thereby increasing the circulation speed of the cooling medium. For example, the cross-sectional structure of the to-be-cooled device 900 is rectangular, and the tube bank structure of the tube bank portion 310 is a rectangular tube bank structure corresponding to the cross-sectional structure. However, the cross-sectional structure of the to-be-cooled device 900 may also be other shapes, and it is required that the tube bank structure of the tube bank portion 310 corresponds to the cross-sectional structure.

In an optional implementation, the cross-sectional structure of the to-be-cooled device 900 is rectangular, and the tube bank portion 310 is a rectangular tube bank structure corresponding to the the cross-sectional structure. The tube bank portion 310 includes two third tube bodies 311 and a plurality of fourth tube bodies 312 connected between the two third tube bodies 311. The plurality of fourth tube bodies 312 are all provided in communication with the two third tube bodies 311. The second diversion portion 320 is provided in communication with any one of the third tube bodies 311, and the second diversion inlets 300 are disposed at the top of the fourth tube bodies 312. The cooling medium flowing through the to-be-cooled device 900 takes away the heat of the to-be-cooled device 900, and then enters the second diversion assembly 30 through the second diversion inlets 300 disposed on the fourth tube bodies 312, and finally is discharged out of the cabinet body 10 through the first diversion outlet 102 of the cabinet body 10. In this way, the purpose of dissipating the heat of the to-be-cooled device 900 is achieved.

In an optional implementation, there are two first diversion outlets 102 disposed on two sides of the cabinet body 10 respectively. Correspondingly, there are two second diversion portions 320 which communicate with the two third tube bodies 311 in one-to-one correspondence. In this way, the circulation speed of the cooling medium can be increased, and further the cooling efficiency of the to-be-cooled device 900 can be improved.

In an optional implementation, the length of the third tube body 311 is shorter than the length of the fourth tube body 312; a reinforcing ring 313 is fitted on the third tube body 311, which can enhance the structural strength of the second diversion assembly 30. Optionally, the plurality of fourth tube bodies 312 include two groups arranged in a staggered manner. One group of the fourth tube bodies 312 and one of the third tube bodies 311 are integrally formed, and the other group of the fourth tube bodies 312 and the other third tube body 311 are integrally provided; that is, the plurality of fourth tubes bodies 312 and the two third tube bodies 311 form an integrated structure of two rakes, which can further enhance the structural strength of the second diversion assembly 30.

In an optional implementation, there are a plurality of second diversion outlets 200, and the plurality of second diversion outlets 200 are evenly arranged on at least one of the first tube bodies 211, the second tube bodies 212, and the first diversion portion 220 of the first diversion assembly 20. In the embodiment shown in the figure, the inner walls of the first tube bodies 211, the second tube bodies 212, and the first diversion portion 220 of the first diversion assembly 20 are all provided with a plurality of evenly arranged second diversion outlets 200. There are a plurality of second diversion inlets 300, and the plurality of second diversion inlets 300 are evenly arranged at the top of the fourth tube bodies 312 of the second diversion assembly 30. In this way, the cooling medium may flow through the to-be-cooled device 900 more evenly, which is beneficial to improving the cooling efficiency.

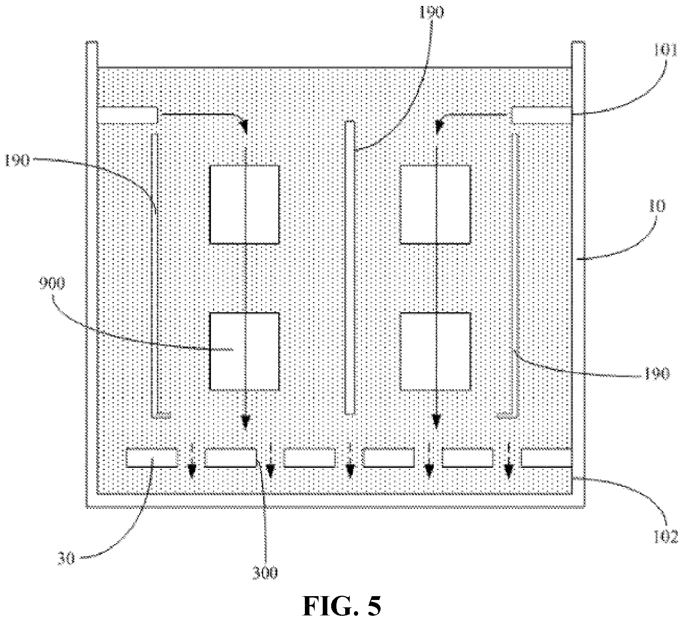

With reference to FIGS 3-5 which show an example where the first diversion inlet 101 is located above the first diversion outlet 102, the first diversion assembly 20 is located at the top of the to-be-cooled device 900, and the second diversion assembly 30 is located at the bottom of the to-be-cooled device 900, the working principle of the cooling cabinet 1 in the present specification will be described. The cooling cabinet 1 of the present specification is provided with a plurality of plug-in components 190 for installing the to-be-cooled devices 900, and the to-be-cooled devices 900 may each be of a sheet-type structure and are plugged in these plug-in components 190 one by one. After entering the first diversion assembly 20 from the first diversion inlet 101 of the cabinet body 10, the cooling medium 80 is discharged into the cabinet body 10 through the second diversion outlet 200 of the first diversion assembly 20 and then flows down through the to-be-cooled devices 900; the cooling medium 80 flowing through the to-be-cooled device 900 takes away the heat of the to-be-cooled device 900, and then enters the second diversion assembly 30 through the second diversion inlet 300 of the second diversion assembly 30, and finally is discharged out of the cabinet body 10 through the first diversion outlet 102 of the cabinet body 10. In this way, the purpose of dissipating the heat of the to-be-cooled device 900 is achieved. The dotted arrows in the figures indicate the flow direction of the cooling medium in the state of a hot liquid fluid, and the solid arrows indicate the flow direction of the cooling medium in the state of a cold liquid fluid. By arranging the first diversion assembly 20 at the top of the to-be-cooled device 900 and arranging the second diversion assembly 30 at the bottom of the to-be-cooled device 900, the flow field of the cooling medium 80 flowing through the to-be-cooled device 900 is a straight path from top to bottom, so that the entire liquid flow path of the cooling medium is the shortest, the resistance is the smallest, and the energy consumption required to drive the liquid is correspondingly greatly reduced, thereby achieving the effect of minimum energy consumption. In addition, the cooling medium flows along a linear flow path, and cold and hot fluids are completely isolated, which can prevent the cold and hot fluids from mixing with each other, thereby achieving the optimal cooling effect.

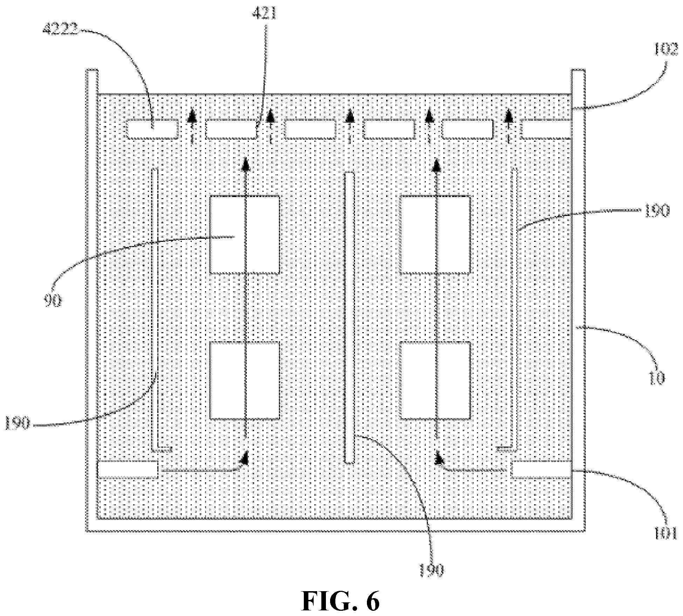

Referring to FIG. 6 which shows an example where the first diversion inlet 101 is located below the first diversion outlet 102, the first diversion assembly 20 is located at the bottom of the to-be-cooled device 900, and the second diversion assembly 30 is located at the top of the to-be-cooled device 900, the working principle of the cooling cabinet 1 in the present specification will be described. The cooling cabinet 1 of the present specification is provided with a plurality of plug-in components 190 for installing the to-be-cooled devices 900, and the to-be-cooled devices 900 may each be of a sheet-type structure and are plugged in these plug-in components 190 one by one. After entering the first diversion assembly 20 from the first diversion inlet 101 of the cabinet body 10, the cooling medium 80 is discharged into the cabinet body 10 through the second diversion outlet 200 of the first diversion assembly 20 and then flows up through the to-be-cooled devices 900; the cooling medium 80 flowing through the to-be-cooled device 900 takes away the heat of the to-be-cooled device 900, and then enters the second diversion assembly 30 through the second diversion inlet 300 of the second diversion assembly 30, and finally is discharged out of the cabinet body 10 through the first diversion outlet 102 of the cabinet body 10. In this way, the purpose of dissipating the heat of the to-be-cooled device 900 is achieved. The dotted arrows in the figures indicate the flow direction of the cooling medium in the state of a hot liquid fluid, and the solid arrows indicate the flow direction of the cooling medium in the state of a cold liquid fluid. By arranging the first diversion assembly 20 at the bottom of the to-be-cooled device 900 and arranging the second diversion assembly 30 at the top of the to-be-cooled device 900, the flow field of the cooling medium 80 flowing through the to-be-cooled device 900 is a straight path from bottom to top, so that the entire liquid flow path of the cooling medium is the shortest, the resistance is the smallest, and the energy consumption required to drive the liquid is correspondingly greatly reduced, thereby achieving the effect of minimum energy consumption. In addition, the cooling medium flows along a linear flow path, and cold and hot fluids are completely isolated, which can prevent the cold and hot fluids from mixing with each other, thereby achieving the optimal cooling effect.

### Embodiment 2

An embodiment of the present specification further provides a cooling cabinet for cooling a to-be-cooled device. The cooling cabinet includes a cabinet body and a diversion assembly disposed in the cabinet body, and the diversion assembly is provided with a plurality of discretely distributed diversion openings. The cabinet body may contain a cooling medium for at least partially immersing the to-be-cooled device, and the cabinet body is provided with a first diversion inlet for introducing the cooling medium and a first diversion outlet for discharging the cooling medium. The diversion assembly is provided in communication with the diversion inlet, and the plurality of diversion openings are configured to discharge the cooling medium into the cabinet body; or the diversion assembly is provided in communication with the diversion outlet, and the plurality of diversion openings are configured to introduce the cooling medium flowing through the to-be-cooled device.

As can be seen from the above technical solutions, in the cooling cabinet of the present description, since a plurality of diversion openings are disposed in a discrete distribution on the diversion assembly, the diversion assembly may be provided in communication with the diversion inlet of the cabinet body, thus introducing the cooling medium. The diversion assembly may also be provided in communication with the diversion outlet of the cabinet body to discharge the cooling medium. However, no matter which arrangement the present specification discloses, the plurality of diversion openings that are discretely distributed can make the cooling medium flow into or out of the cabinet body from multiple different directions, reducing the temperature difference between the cooling mediums, thereby making the flow and temperature of the cooling medium more uniform and achieving higher cooling efficient.

It should be noted that, when the diversion assembly is provided in communication with the diversion inlet, the diversion assembly functions as the first diversion assembly described in Embodiment 1, and the diversion openings function as the second diversion outlet described in Embodiment 1; in this case, for the structure of the diversion assembly, reference may be made to the description of the first diversion assembly in Embodiment 1. When the diversion assembly is provided in communication with the diversion outlet, the diversion assembly functions as the second diversion assembly described in Embodiment 1, and the diversion openings function as the second diversion inlet described in Embodiment 1; in this case, for the structure of the diversion assembly, reference may be made to the description of the second diversion assembly in Embodiment 1.

### Embodiment 3

An embodiment of the present specification further provides a cooling system, including the cooling cabinet as described in Embodiment 1 or Embodiment 2 above and a heat exchanging device connected to the cooling cabinet. It should be noted that the description of the cooling cabinet in the Embodiments 1 and 2 above is also applicable to the cooling system of the present specification. The cooling system described in Embodiment 1 is taken as an example to describe the cooling system of the present specification.

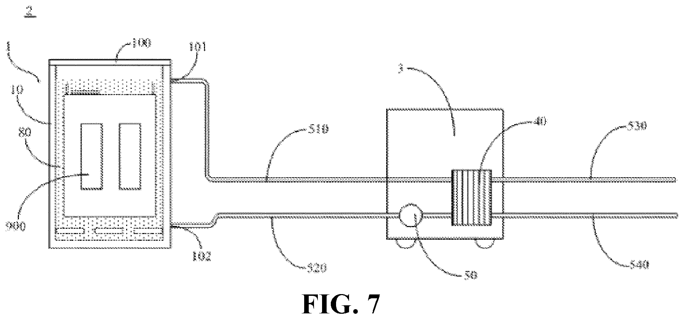

Referring to FIG. 7, the cooling system 2 of the present specification includes the cooling cabinet 1 described in Embodiment 1 and a heat exchanging device 3 connected to the cooling cabinet 1. One end of the heat exchanging device 3 is provided in communication with the cabinet body 10 of the cooling cabinet 1, and the other end of the heat exchanging device 3 is provided in communication with an external liquid supply device. The heat exchanging device 3 is configured to drive the cooling medium to circulate in the cabinet body 10 of the cooling cabinet 1 and exchange heat with the cooling medium.

As can be seen from the above technical solutions, the cooling system 2 of the present specification drives the cooling medium to circulate in the cooling cabinet 1 through the heat exchanging device 3 to take away the heat of the to-be-cooled device 900, and exchanges heat with the external liquid supply device through the heat exchanging device 3, so that the cooling medium reaches a low temperature state again, and circulates into the cooling cabinet 1 to cool the to-be-cooled device 900 again, thus achieving the purpose of circularly and continuously cooling the to-be-cooled device 900.

In an optional embodiment, the heat exchanging device 3 includes a heat exchanger 40 and a pump 50. The heat exchanger 40 is connected to the cooling cabinet 1 through a first circulation loop, and is connected to the external liquid supply device through a second circulation loop. The first circulation loop includes a first pipeline 510 and a second pipeline 520, and the second circulation loop includes a third pipeline 530 and a fourth pipeline 540. The first pipeline 510 is provided in communication with the first diversion inlets 101 of the cooling cabinet 1, the second pipeline 520 is provided in communication with the first diversion outlets 102 of the cooling cabinet 1, and the third pipeline 530 and the fourth pipeline 540 are both provided in communication with the external liquid supply device. When the cooling system 2 of the present specification is in operation, the pump 50 drives the cooling medium to circulate in the cooling cabinet 1 through the first circulation loop, and the cooling medium takes away the heat of the to-be-cooled device 900 through the circulation in the cooling cabinet 1 and enters the heat exchanger 40 of the heat exchanging device 3. The external liquid supply device can circulate cooling water in the second circulation loop, and the cooling system carrying the heat of the to-be-cooled device 900 may exchanges heat in the heat exchanger 40 with the cooling water provided by the external liquid supply device to discharge the heat carried by the cooling system, so that the cooling medium reaches a low temperature state again, and circulates into the cooling cabinet 1 to cool the to-be-cooled device 900 again, thus achieving the purpose of circularly and continuously cooling the to-be-cooled device 900.

It should be further noted that the term "include", "comprise" or any other variations thereof are intended to cover non-exclusive inclusions such that a process, method, article, or device that includes a series of elements not only includes those elements but also includes other elements that are not listed explicitly, or also include inherent elements of the process, method, article, or device. In the absence of more limitations, an element defined by the sentence "including a/an..." does not exclude that the process, method, article or device including the element further has other identical elements.

## Claims

1. A cooling cabinet (1) for a plurality of data center server devices, comprising:
a cabinet body (10) configured to contain cooling medium for at least partially immersing the plurality of data center server devices;
the cabinet body comprising a first diversion inlet (101) and a first diversion outlet (102); wherein the first diversion inlet is through the cabinet body and is for receiving the cooling medium, and the first diversion outlet is through the cabinet body and is for discharging the collected cooling medium;
a first diversion assembly (20) coupled to the cabinet body, wherein the first diversion assembly includes a loop tube portion (210) and
a first diversion portion (220) coupled to the loop tube portion and to the first diversion inlet, and second diversion outlets (200), wherein the second diversion outlets (200) are evenly arranged along at least one of the loop tube portion and the first diversion portion for introducing the received cooling medium into the cabinet body; and
a second diversion assembly (30) coupled to the cabinet body, wherein the second diversion assembly includes a tube bank portion (310) and
a second diversion portion (320) coupled to the first diversion outlet (102) and the tube bank portion, and wherein the tube bank portion comprises second diversion inlets (300), wherein the second diversion inlets are evenly arranged along the tube bank portion for collecting the cooling medium from the cabinet body;
**characterized in that** the first diversion assembly (20) and second diversion assembly (30) are arranged on two opposite sides of the plurality of data center server devices in the vertical direction so that the flow field of the cooling medium flows through the plurality of data center servers in a straight path in the vertical direction between the second diversion outlets (200) of the first diversion assembly and the second diversion inlets (300) of the second diversion assembly.

2. The cooling cabinet according to claim 1, wherein the loop tube portion is a rectangular loop tube structure and comprises two first tube bodies (211) and two second tube bodies (212) coupled to each other, wherein two first diversion portions are coupled to the two first tube bodies in one-to-one correspondence, and wherein the second diversion outlets are arranged on the at least one of the two first tube bodies and the two second tube bodies and two first diversion portions;
wherein the cooling cabinet includes two first diversion inlets, which are respectively disposed on two sides of the cabinet body, and wherein the two first diversion portions are coupled to the two first tube bodies in one-to-one correspondence; and
wherein each of the two first tube bodies are integrally formed with the adjacent second tube bodies in one-to-one correspondence.

3. The cooling cabinet according to claim 1, wherein the tube bank portion is a rectangular tube bank structure and comprises two third tube bodies (311) and a plurality of fourth tube bodies (312) connected between the two third tube bodies; wherein the second diversion inlets are arranged on the plurality of fourth tube bodies.

4. The cooling cabinet according to claim 3, wherein the cooling cabinet includes two first diversion outlets, which are respectively disposed on two sides of the cabinet body, and two second diversion portions coupled to the two third tube bodies in one-to-one correspondence; and
wherein the plurality of fourth tube bodies include two groups of the fourth tube bodies arranged in a staggered manner; wherein one group of the fourth tube bodies and one of the third tube bodies are integrally formed, and the other group of the fourth tube bodies and the other third tube body are integrally formed.

5. A cooling system including the cooling cabinet according to claim 1, further including:
a heat exchanging device (3) coupled to the cooling cabinet (1) wherein one end of the heat exchanging device is coupled to the cabinet body and another end of the heat exchanging device is adapted to be coupled to an external liquid supply device, and wherein the heat exchanging device is configured to drive the cooling medium to circulate in the cabinet body and exchange heat with the cooling medium.

## Patentansprüche

1. Kühlschrank (1) für eine Vielzahl von Rechenzentrums-Servervorrichtungen, umfassend:
einen Schrankkörper (10), der dazu konfiguriert ist, Kühlmedium zum zumindest teilweisen Eintauchen der Vielzahl von Rechenzentrums-Servervorrichtungen zu enthalten;
wobei der Schrankkörper einen ersten Ablenkungseinlass (101) und einen ersten Ablenkungsauslass (102) umfasst; wobei der erste Ablenkungseinlass durch den Schrankkörper verläuft und zum Aufnehmen des Kühlmediums dient und der erste Ablenkungsauslass durch den Schrankkörper verläuft und zum Ableiten des gesammelten Kühlmediums dient;
eine erste Ablenkungsanordnung (20), die an den Schrankkörper gekoppelt ist, wobei die erste Ablenkungsanordnung einen Schleifenrohrabschnitt(210) und
einen ersten Ablenkungsabschnitt (220), der an den Schleifenrohrabschnitt und an den ersten Ablenkungseinlass gekoppelt ist, und zweite Ablenkungsauslässe (200) beinhaltet, wobei
die zweiten Ablenkungsauslässe (200) gleichmäßig entlang mindestens einem von dem Schleifenrohrabschnitt und dem ersten Ablenkungsabschnitt angeordnet sind, um das aufgenommene Kühlmedium in den Schrankkörper einzuleiten; und
eine zweite Ablenkungsanordnung (30), die an den Schrankkörper gekoppelt ist, wobei die zweite Ablenkungsanordnung einen Rohrbankabschnitt (310) und
einen zweiten Ablenkungsabschnitt (320), der an den ersten Ablenkungsauslass (102) und den Rohrbankabschnitt gekoppelt ist, beinhaltet, und wobei der Rohrbankabschnitt zweite Ablenkungseinlässe (300) umfasst, wobei die zweiten Ablenkungseinlässe gleichmäßig entlang des Rohrbankabschnitts angeordnet sind, um das Kühlmedium aus dem Schrankkörper zu sammeln;
**dadurch gekennzeichnet, dass** die erste Ablenkungsanordnung (20) und die zweite Ablenkungsanordnung (30) an zwei gegenüberliegenden Seiten der Vielzahl von Rechenzentrums-Servervorrichtungen in der vertikalen Richtung angeordnet sind, sodass das Strömungsfeld des Kühlmediums durch die Vielzahl von Rechenzentrums-Servern in einem geraden Weg in der vertikalen Richtung zwischen den zweiten Ablenkungsauslässen (200) der ersten Ablenkungsanordnung und den zweiten Ablenkungseinlässen (300) der zweiten Ablenkungsanordnung strömt.

2. Kühlschrank nach Anspruch 1, wobei der Schleifenrohrabschnitt eine rechteckige Schleifenrohrstruktur ist und zwei erste Rohrkörper (211) und zwei zweite Rohrkörper (212) umfasst, die aneinander gekoppelt sind, wobei zwei erste Ablenkungsabschnitte an die zwei ersten Rohrkörper in Eins-zu-Eins-Entsprechung gekoppelt sind, und wobei die zweiten Ablenkungsauslässe an dem mindestens einen von den zwei ersten Rohrkörpern und den zwei zweiten Rohrkörpern und zwei ersten Ablenkungsabschnitten angeordnet sind;
wobei der Kühlschrank zwei erste Ablenkungseinlässe beinhaltet, die jeweils an zwei Seiten des Schrankkörpers angeordnet sind, und wobei die zwei ersten Ablenkungsabschnitte an die zwei ersten Rohrkörper in einer Eins-zu-Eins-Entsprechung gekoppelt sind; und
wobei jeder der zwei ersten Rohrkörper einstückig mit den benachbarten zweiten Rohrkörpern in einer Eins-zu-Eins-Entsprechung ausgebildet ist.

3. Kühlschrank nach Anspruch 1, wobei der Rohrbankabschnitt eine rechteckige Rohrbankstruktur ist und zwei dritte Rohrkörper (311) und eine Vielzahl von vierten Rohrkörpern (312) umfasst, die zwischen den zwei dritten Rohrkörpern angeschlossen sind; wobei die zweiten Ablenkungseinlässe an der Vielzahl von vierten Rohrkörpern angeordnet sind.

4. Kühlschrank nach Anspruch 3, wobei der
Kühlschrank zwei erste Ablenkungsauslässe, die jeweils an zwei Seiten des Schrankkörpers angeordnet sind, und zwei zweite Ablenkungsabschnitte, die an die zwei dritten Rohrkörper in einer Eins-zu-Eins-Entsprechung gekoppelt sind, beinhaltet; und
wobei die Vielzahl von vierten Rohrkörpern zwei Gruppen der vierten Rohrkörper beinhaltet, die in einer versetzten Weise angeordnet sind; wobei eine Gruppe der vierten Rohrkörper und einer der dritten Rohrkörper einstückig ausgebildet sind und die andere Gruppe der vierten Rohrkörper und der andere dritte Rohrkörper einstückig ausgebildet sind.

5. Kühlsystem, das den Kühlschrank nach Anspruch 1 beinhaltet, ferner beinhaltend:
eine Wärmeaustauschvorrichtung (3), die an den Kühlschrank (1) gekoppelt ist, wobei ein Ende der Wärmeaustauschvorrichtung an den Schrankkörper gekoppelt ist und ein anderes Ende der Wärmeaustauschvorrichtung dazu angepasst ist, an eine externe Flüssigkeitszufuhrvorrichtung gekoppelt zu werden, und wobei die Wärmeaustauschvorrichtung dazu konfiguriert ist, das Kühlmedium dazu anzutreiben, in dem Schrankkörper zu zirkulieren und Wärme mit dem Kühlmedium auszutauschen.

## Revendications

1. Armoire de refroidissement (1) pour une pluralité de dispositifs de serveur de centre de données, comprenant :
un corps d'armoire (10) conçu pour contenir un milieu de refroidissement permettant d'immerger au moins partiellement la pluralité de dispositifs de serveur de centre de données ;
le corps d'armoire comprenant une première entrée de dérivation (101) et une première sortie de dérivation (102) ;
dans laquelle la première entrée de dérivation se trouve au travers du corps d'armoire et permet de recevoir le milieu de refroidissement, et la première sortie de dérivation se trouve au travers du corps d' armoire et permet de décharger le milieu de refroidissement collecté ;
un premier ensemble de dérivation (20) couplé au corps d' armoire, dans laquelle le premier ensemble de dérivation comprend une partie de tube en boucle (210) et
une première partie de dérivation (220) couplée à la partie de tube en boucle et à la première entrée de dérivation, et des secondes sorties de dérivation (200), dans laquelle les secondes sorties de dérivation (200) sont agencées uniformément le long d'au moins l'une de la partie de tube en boucle et de la première partie de dérivation permettant d'introduire le milieu de refroidissement reçu dans le corps d'armoire ; et
un second ensemble de dérivation (30) couplé au corps d'armoire, dans laquelle le second ensemble de dérivation comprend une partie de rangée de tubes (310) et
une seconde partie de dérivation (320) couplée à la première sortie de dérivation (102) et à la partie de rangée de tubes, et dans laquelle la partie de rangée de tubes comprend des secondes entrées de dérivation (300), dans laquelle les secondes entrées de dérivation sont disposées uniformément le long de la partie de rangée de tubes permettant de collecter le milieu de refroidissement à partir du corps d'armoire ;
**caractérisée en ce que** le premier ensemble de dérivation (20) et le second ensemble de dérivation (30) sont agencés sur deux côtés opposés de la pluralité de dispositifs de serveur de centre de données dans la direction verticale de sorte que le champ d'écoulement du milieu de refroidissement s'écoule à travers la pluralité de serveurs de centre de données dans un chemin droit dans la direction verticale entre les secondes sorties de dérivation (200) du premier ensemble de dérivation et les secondes entrées de dérivation (300) du second ensemble de dérivation.

2. Armoire de refroidissement selon la revendication 1, dans laquelle la partie de tube en boucle est une structure de tube en boucle rectangulaire et comprend deux premiers corps de tube (211) et deux deuxièmes corps de tube (212) couplés l'un à l'autre, dans laquelle deux premières parties de dérivation sont couplées aux deux premiers corps de tube en correspondance biunivoque, et dans laquelle les secondes sorties de dérivation sont agencées sur l'au moins un des deux premiers corps de tube et des deux deuxièmes corps de tube et deux premières parties de dérivation ;
dans laquelle l'armoire de refroidissement comprend deux premières entrées de dérivation, qui sont respectivement disposées sur deux côtés du corps d'armoire, et dans laquelle les deux premières parties de dérivation sont couplées aux deux premiers corps de tube en correspondance biunivoque ; et
dans laquelle chacun des deux premiers corps de tube est formé d'un seul tenant avec les deuxièmes corps de tube adjacents en correspondance biunivoque.

3. Armoire de refroidissement selon la revendication 1, dans laquelle la partie de rangée de tubes est une structure de rangée de tubes rectangulaire et comprend deux troisièmes corps de tube (311) et une pluralité de quatrièmes corps de tube (312) reliés entre les deux troisièmes corps de tube ; dans laquelle les secondes entrées de dérivation sont agencées sur la pluralité de quatrièmes corps de tube.

4. Armoire de refroidissement selon la revendication 3, dans laquelle l'armoire de refroidissement comprend deux premières sorties de dérivation, qui sont respectivement disposées sur deux côtés du corps d'armoire, et deux secondes parties de dérivation couplées aux deux troisièmes corps de tube en correspondance biunivoque ; et
dans laquelle la pluralité de quatrièmes corps de tube comprend deux groupes des quatrièmes corps de tube agencés en quinconce ; dans laquelle un groupe des quatrièmes corps de tube et un des troisièmes corps de tube sont formés d'un seul tenant, et l'autre groupe des quatrièmes corps de tube et l' autre troisième corps de tube sont formés d'un seul tenant.

5. Système de refroidissement comprenant l'armoire de refroidissement selon la revendication 1, comprenant en outre :
un dispositif d'échange de chaleur (3) couplé à l'armoire de refroidissement (1), dans lequel une extrémité du dispositif d' échange de chaleur est couplée au corps d'armoire et une autre extrémité du dispositif d'échange de chaleur est adaptée pour être couplée à un dispositif d' alimentation en liquide externe, et dans lequel le dispositif d' échange de chaleur est conçu pour entraîner le milieu de refroidissement à circuler dans le corps d'armoire et échanger de la chaleur avec le milieu de refroidissement.
